Europäisches Patentamt

European Patent Office

Office européen des brevets

(11) Publication number: **0 143 496**
**B1**

(12) **EUROPEAN PATENT SPECIFICATION**

(45) Date of publication of patent specification: 27.01.88

(51) Int. Cl.⁴: **H 01 L 27/14**

(21) Application number: **84201684.2**

(22) Date of filing: **20.11.84**

(54) **Blooming-insensitive image sensor device and method of manufacturing same.**

(30) Priority: **24.11.83 NL 8304035**

(43) Date of publication of application:
**05.06.85 Bulletin 85/23**

(45) Publication of the grant of the patent:
**27.01.88 Bulletin 88/04**

(84) Designated Contracting States:
**AT BE DE FR GB IT NL SE**

(56) References cited:
**GB-A-2 054 961**
**GB-A-2 069 759**
**US-A-4 025 943**

**IBM TECHNICAL DISCLOSURE BULLETIN, Vol. 15, No. 9, February 1973, NEW YORK (US). Pages 2707-2708. D.R. YOUNG: "Reducing detrimental minority carrier effects in semiconductor devices".**

(73) Proprietor: **N.V. Philips' Gloeilampenfabrieken**
**Groenewoudseweg 1**
**NL-5621 BA Eindhoven (NL)**

(72) Inventor: **Boudewijns, Arnoldus Johannes Juliana**
**c/o INT. OCTROOIBUREAU B.V. Prof. Holstlaan 6**
**NL-5656 AA Eindhoven (NL)**

(74) Representative: **Rensen, Jan Geert et al**
**Internationaal Octrooibureau B.V. Prof. Holstlaan 6**
**NL-5656 AA Eindhoven (NL)**

Courier Press, Leamington Spa, England.

## Description

The invention relates to an image sensor device comprising a semiconductor substrate of a first conductivity type having a number of surface-adjoining channel regions of the first conductivity type which are directed at right angles to a system of electrodes present on and insulated from the surface, in which during operation charge produced by incident radiation is collected and transported and which are mutually separated by surface-adjoining channel separation zones of the second opposite conductivity type and further adjoin a semiconductor zone of the second conductivity type extending substantially parallel to the surface, the channel regions having a dopant concentration which exceeds that of the semiconductor zone, which in turn exceeds the doping concentration of the semiconductor substrate.

The invention further relates to a method of manufacturing such a device.

In such an image sensor device described in GB—A—2069759, during operation such voltages are applied to the electrodes that a pattern of potential wells mutually separated by potential barriers is formed in the channel regions. For a given integration time, charge produced in the semiconductor material by incident radiation is collected in these potential wells. Thus, a charge image corresponding to a radiation image is formed. After the integration time, clock voltages are applied to the electrodes, as a result of which the collected charge packets are transported through the channel regions and are transferred, for example, to a storage register. Such a method is the so-called frame- or field transfer method. Subsequently, the charge is further processed during the next integration period to television input signals.

Due to the presence of the semiconductor zone extending substantially parallel to the surface, the application of suitable voltages between the electrodes, the semiconductor zone and the substrate will result in a potential variation between the surface and the substrate which exhibits a potential barrier at the area of the semiconductor zone. Thus, charge which, viewed from the surface, is produced above this potential barrier in the semiconductor material will contribute to the formation of the charge image, whereas charge produced beneath this potential barrier will not contribute to the formation of the charge image. Since long-wave radiation can penetrate more deeply into the semiconductor material than short-wave radiation, the spectral sensitivity of the image sensor device is determined by the position of the potential barrier.

GB—A—2054961 discloses an image sensor device of the kind mentioned in the opening paragraph in which the channel regions have a doping concentration which does not exceed that of the semiconductor zone and the substrate. As a result, charge collected in the channel regions can influence the potential variation between the surface and the semiconductor substrate in such a manner that the potential barrier, which was initially present at the area of the semiconductor zone, disappears when a given quantity of charge is exceeded during the integration period. When during the integration period, due to a local strong irradiation such a quantity of charge is locally produced that the said given quantity is exceeded, the excess of charge can flow away to the semiconductor substrate. Thus, it can be prevented that this excess of charge can spread over a large number of adjacent potential wells present in the channel regions during the integration period. This phenomenon often designated as "blooming" can give rise to very disturbing lines in a television picture, which is formed by means of signals obtained with such an image sensor device.

The known image sensor device comprises a semiconductor substrate on which two semiconductor layers are disposed of which the upper layer comprises the channel regions having a doping concentration which does not exceed that of the semiconductor substrate. Such a construction cannot be obtained by means of diffusion of impurities in semiconductor materials. In the case of diffusion of impurities in a semiconductor body of the one conductivity type, only a zone of the other conductivity type can be formed whose doping concentration exceeds that of the semiconductor body. In order to be able to manufacture the known image sensor device, a layer of the first conductivity type will have to be grown epitaxially onto a semiconductor substrate. In this layer structure, channel separation zones extending into the semiconductor zone can be formed by means of diffusion of impurities in both layers.

Another disadvantage of the known image sensor device is that the channel regions have a width which is determined during the manufacture of the channel separation zones. This zones will have a minimum width which is equal to the minimum dimensions of a window required for the diffusion, plus on both sides the distance over which lateral diffusion takes place. This distance is larger in the known image sensor device than the thickness of the layer in which the channel regions are formed. Starting from a desired centre distance between adjacent channel regions, the desired centre distance minus the width of the required diffusion window and well over twice the thickness of the channel regions is then left for the width of the channel regions. In practice, the desired centre distance is, for example, 10 μm, the width of the window is 4 μm and the thickness of the channel regions is 1 μm; for the width of the channel regions only about 3 μm is left.

The known image sensor device consequently has comparatively narrow channel regions and comparatively wide channel separation zones. This is an undesirable situation because thus not only the quantity of charge that can be collected and transported per unit surface area is comparatively small, but also the image sensor device consequently has a comparatively low sensitivity. Charge produced in the channel separation zones can flow away to the semiconductor substrate and will then not contribute to the image formation.

The invention has *inter alia* for its object to provide an image sensor device of the kind mentioned in the opening paragraph, in which charge collected in the channel regions also can influence the potential variation between the surface and the semiconductor substrate in such a manner that an excess of charge can flow away to the semiconductor substrate and which has comparatively wide channel regions and comparatively narrow channel separation zones.

The image sensor device of the kind mentioned in the opening paragraph in accordance with the invention is characterized in that the semiconductor zone has a thickness which varies in the direction at right angles to the channel regions, the thickness housing minima at the centres of the channel regions.

The image sensor device according to the invention can be manufactured in a simple manner by means of diffusion of impurities in a semiconductor substrate of the first conductivity type. Thus, zones of the second conductivity type can be provided by means of a first masking with windows extending at a fixed relative centre distance and then zones of the first conductivity type forming the channel regions can be provided by means of a second masking with windows extending at the same relative centre distance. The second masking is then arranged so that the channel regions are formed halfway between the zones of the second conductivity type. The channel regions are then mutually separated by surface-adjoining zones of the second conductivity type (the channel separation zones), while they further adjoin a zone of the second conductivity type extending substantially parallel to the surface. This zone has a thickness, which extends in a direction at right angles to the channel regions and has minima at the centres of the channel regions. The channel regions have a doping concentration which exceeds that of the subjacent semiconductor zone, while the latter in turn has a doping concentration which exceeds that of the semiconductor substrate. As a result, an effective anti-blooming is possible.

In the image sensor device according to the invention, the width of the channel regions is equal to the width of the windows in the second masking plus the distance over which lateral diffusion takes place. This distance is substantially equal to the thickness of the channel regions. In this case a limiting factor is the minimum distance which has to be observed between two windows. With a desired centre distance between the channel regions, the maximum width of these channel regions is equal to this centre distance minus the minimum window distance and plus twice the thickness of the channel regions. In a practical embodiment corresponding to the foregoing, the centre distance is 10 µm, the minimum window width is 4 µm and the thickness of the channel regions is 1 µm; the width of the channel regions then becomes at least 8 µm. As compared with the known image sensor device, the image sensor device according to the invention has comparatively wide channel regions and comparatively narrow channel separation zones.

The invention further relates to a method of manufacturing an image sensor device of the kind mentioned in the opening paragraph. This method is characterized in that zones of the second conductivity type are provided in a semiconductor substrate of the first conductivity type by means of diffusion of impurities through a first masking with windows extending at a fixed relative centre distance and then zones of the first conductivity type forming the channel regions are provided through a second masking with windows extending at the same relative centre distance, the second masking being arranged so that the channel regions are formed halfway between the zones of the second conductivity type.

Thus, by means of simple diffusion techniques, an image sensor device is obtained, in which the channel regions are mutually separated by surface-adjoining semiconductor zones of the second conductivity type (the channel separation zones) and which further adjoin a semiconductor zone of the second conductivity type. The channel regions have a ˙doping concentration which exceeds that of the semiconductor zone, which in turn has a doping concentration which exceeds that of the semiconductor substrate. The semiconductor zone has a thickness which has in the direction at right angles to the channel regions a variation with minima at the centres of the channel regions. The image sensor thus formed can be used in a manner such that the occurrence of blooming is strongly suppressed.

The invention will be described more fully hereinafter by way of example with reference to the drawing. In the drawing:

Fig. 1 shows diagrammatically in plan view an embodiment of the image sensor device according to the invention,

Fig. 2 is a sectional view of the image sensor device of Fig. 1 taken on the line II—II,

Fig. 3 is a sectional view of the image sensor device of Fig. 1 taken on the line III—III,

Fig. 4 shows the potential variation in the image sensor device according to the invention in a direction at right angles to the surface, and

Figures 5, 6 and 7 show successive stages in the manufacture of the image sensor device shown in Figures 1, 2 and 3.

The Figures are schematic and not drawn to scale, whilst for the sake of clarity in the cross-sections especially the dimensions in the direction of thickness are greatly exaggerated. Semiconductor zones of the same conductivity type are cross-hatched in the same direction; corresponding parts are generally denoted by the same reference numerals.

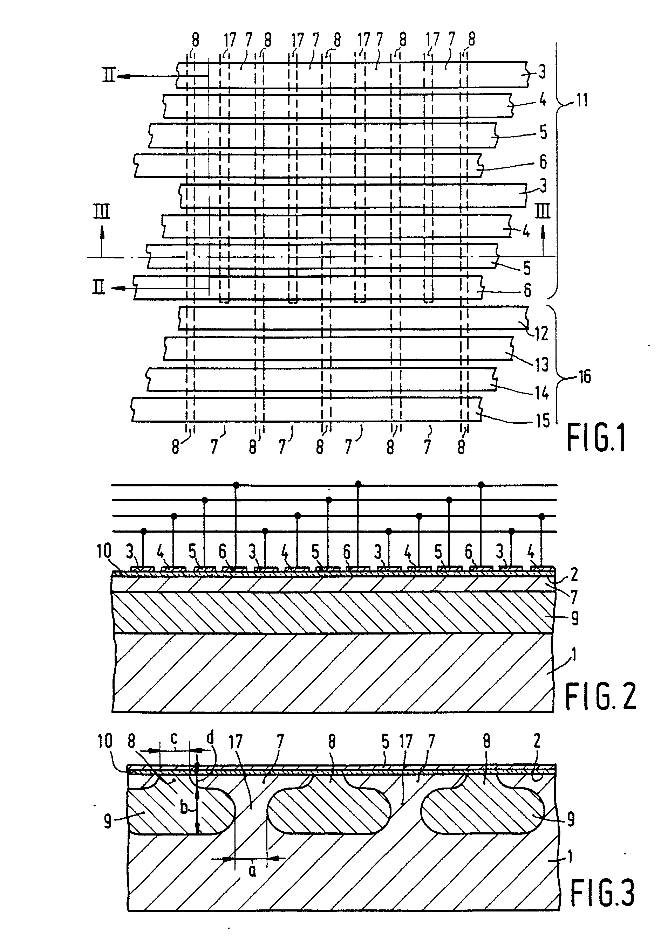

Figures 1 to 3 show diagrammatically an image, sensor device comprising a semiconductor substrate 1 of a first conductivity type, in the example an $n$-type silicon substrate. A surface 2 thereof is adjoined by a number of channel regions 7 of the first conductivity type which are directed at right angles to a system of electrodes 3, 4, 5 and 6 present on the surface, in which during operation charge is collected and transported and which are mutually separated by channel separation zones 8 of the second opposite conductivity type adjoining the surface 2 and which further adjoin a semiconductor zone 9 of the second conductivity type extending substantially parallel to the surface 2. The electrodes 3, 4, 5 and 6 are insulated from the surface 2 by an insulating layer 10 of, for example, silicon oxide.

During operation, as will be described hereinafter, such voltages are applied to the electrodes 3, 4, 5 and 6 that a pattern of potential wells mutually separated by potential barriers located, for example, beneath the electrodes 3 is formed in the channel regions 7. In these potential wells formed beneath the electrodes 4, 5 and 6, charge produced in the semiconductor material 7 and 9 by incident radiation is collected for a given integration time. Thus, in a first part 11 of the image sensor device a charge image is formed which corresponds to a radiation image. After the integration time, clock pulses are applied to the electrodes 3, 4, 5 and 6 and to electrodes 12, 13, 14 and 15, as a result of which the collected charge packets are transported through the channel regions 7 and are transferred, for example, to a storage register 16. The charge can then be read from this register during a next integration time for further signal processing. The storage register 16 is covered by a reflecting aluminium layer not shown so that the charge in this register cannot be modified by incident radiation.

During operation, voltages are applied between the electrodes, 3, 4, 5 and 6 and the substrate 1, as a result of which a potential barrier is formed at the area of the semiconductor zone 9. Charge produced above this potential barrier will contribute to the formation of the charge image, whereas charge produced beneath this potential barrier will not contribute to the formation of this charge image. Since long-wave radiation can penetrate more deeply into the semiconductor material than short-wave radiation, the spectral sensitivity of the image sensor device can be determined by the choice of the position of the potential barrier.

According to the invention, in the image sensor device of the kind described with reference to Figure 1, 2 and 3, the channel regions 7 have a doping concentration which exceeds that of the semiconductor zone 9, which in turn exceeds that of the substrate 1. In the example, the doping concentration of the $n$-type channel regions is about $10^{16}$ atoms/cm$^3$, the doping concentration of the $p$-type semiconductor zone 9 is about $3.10^{15}$ atoms/cm$^3$ and the doping concentration of the $n$-type substrate 1 is about $5.10^{14}$ atoms/cm$^3$. The

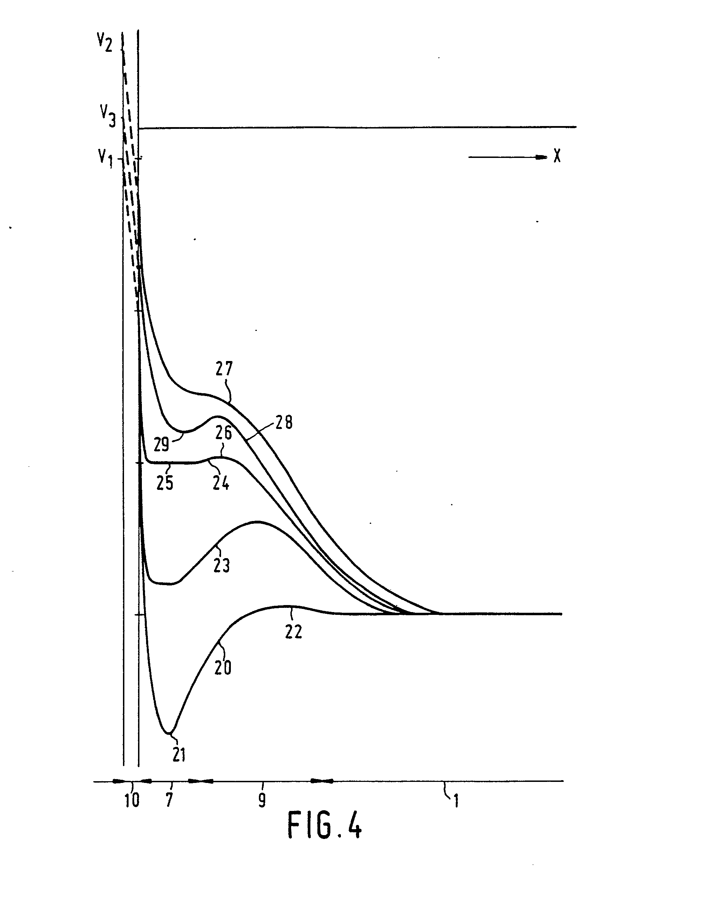

semiconductor zone 9 further has a thickness which has in the direction at right angles to the channel regions 7 a variation with minima at the centres of the channel regions 7. Due to these measures, the potential in the image sensor device will have a variation in the direction at right angles to the surface 2 as shown diagrammatically in Figure 4. In this Figure, the potential V at the centre of the channel regions 7 is indicated as a function of the distance X from the surface 2. The semiconductor zone 9 is then connected to earth potential and the semiconductor substrate 1 is connected to a voltage of about $+15$ V. The curve 20 indicates in this Figure the potential variation at the beginning of an integration period. The potential variation has a potential well 21 which is located in the channel region 7 and a potential barrier 22 which is located at a depth of the semiconductor 9. During the integration period, the potential variation can vary *via* the curve 23 to the curve 24 due to the negative charge collected in the channel region 7. When the situation indicated by the curve 24 is reached, only such a small potential barrier 26 is still present between the potential well 25 in the channel region 7 and the substrate 1 that, when at this area a further quantity of charge is produced, this charge can flow away to the substrate 1. Potential wells can be formed in the longitudinal direction of the channel regions by applying to the electrodes 3, for example, a voltage $V_2$ and by applying to the electrodes 4, 5 and 6 the voltage $V_1$; beneath the electrodes 4, 5 and 6 the potential variation 20, 23, and 24 is then obtained, while beneath the electrode 3 the potential variation 27 is obtained. (In the Figure, the voltage drop across the insulating layer 10 is indicated by dotted lines). Thus, it is achieved that an excess of charge in such a potential well will flow away to the substrate 1 instead of to adjacent potential wells in the channel region 7. This phenomenon, which is often designated as "blooming", can give rise to very disturbing lines in a television picture which is formed by means of signals obtained with such an image sensor device.

The "anti-blooming" described can be realized with very practical voltages between the electrodes 3, 4, 5 and 6 and the substrate if, according to a preferred embodiment of the invention, the semiconductor zone 9 is interrupted at the centres of the channel regions 7 and exhibits slots 17 at this area.

As will appear from the following, the image sensor device can be manufactured in a simple manner, whereby the width of the channel regions 7 can be comparatively large and the width of the channel separation zones 8 can be comparatively small. The image sensor device according to the invention thus has a comparatively high sensitivity.

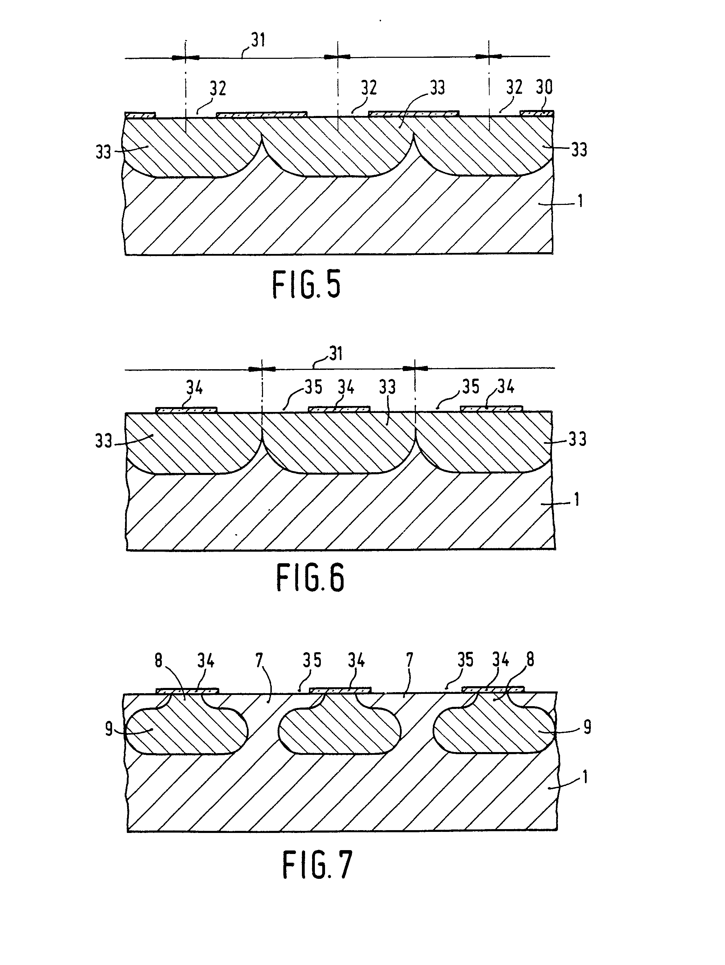

Figures 5, 6 and 7 show a few successive stages in the manufacture of the image sensor device shown in Figures 1 to 3. Fig. 5 shows the stage at which there are provided in a semiconductor substrate 1 of the first conductivity type, in this case $n$-type silicon having an average doping concentration of about $5.10^{14}$ atoms/cm$^3$, zones 33 of the second conductivity type, so in this case $p$-type, by means of a usual diffusion of impurities *via* a masking 30 of, for example, silicon oxide with windows 32 extending at a fixed relative centre distance 31. These zones 33 have an average doping concentration of about $3.10^{15}$ atoms/cm$^3$. Subsequently, as shown in Figure 6, zones of the first conductivity type, so in this case $n$-type, forming the channel regions 7 are provided *via* a second masking 34, for example also of silicon oxide, with windows 35 extending at the same relative centre distance 31 by means of a usual diffusion of impurities so that the structure shown in Figure 7 is formed. The second masking 34 is then arranged so that the channel regions 7 are formed halfway between the zones 33. The channel regions 7 are then mutually separated by channel separation zones 8, while they further adjoin the zone 9 extending substantially parallel to the surface 2. This zone 9 has a thickness which extends in the direction at right angles to the channel regions and has minima at the centres of the channel regions 7. The channel regions 7 have a doping concentration, in this embodiment of about $10^{16}$ atoms/cm$^3$ on an average, which exceeds that of the zone 9, which is in the embodiment about $3.10^{15}$ atoms/cm$^3$ on an average and which in turn exceeds that of the substrate 1, which is in the embodiment about $5.10^{14}$ atoms/cm$^3$.

The width of the channel regions 7 is equal to the width of the windows 35 in the second masking 34 plus the distance over which lateral diffusion of the channel regions 7 beneath the masking 34 occurs. This distance is approximately equal to the thickness of the channel regions 7 and amounts, for example, to 1 µm. A limiting factor is the minimum distance which has to be observed between two adjacent windows 35. If a mask can be realized in which this distance is 4 µm, the width of the channel regions becomes about 8 µm and the width of the channel separation zones 8 becomes about 2 µm when the centre distance is 10 µm.

After an insulating layer 10 and a system of electrodes 3, 4, 5, 6 and 12, 13, 14, 15 have been provided in a usual manner after removal of the masking 34, the structure of Figures 1 to 3 is obtained. In Figure 1, the slots 17 do not extend beneath the electrodes 12, 13, 14, 15 of the storage register 16 because they do not fulfil a function here; however, there is no objection against providing them here too.

Preferably, the slots 17 have in the direction at right angles to the channels 7 a dimension $a$, which exceeds half the thickness $b$ of the semiconductor zone 9, measured just beside the channel separation zones 8. In this case, at a substrate voltage of +15 V and a voltage at the channel separation zones of O V, $V_1$ can be about O V and $V_2$ can be about −5 V.

In order to utilize charge present in the channel separation zones 8 as far as possible, the channel separation zones 8 have in the direction at right angles to the channel regions preferably a dimension $c$ which is smaller than four times the thickness $d$ of the channel regions 7, measured just beside the channel separation zones 8. Thus, it is ensured that in the direction at right angles to the channel regions 7 a potential variation is obtained which causes charge produced in the channel separation zones 8 to flow to the adjacent channel zones 7 and not to the substrate 1 *via* the zone 9.

The slots 17 are obtained in a simple manner when the aforementioned two diffusions are effected so that the zones 9 of the second conductivity type do not contact each other, but are separated by regions 7,1 of the first conductivity type.

As a matter of course, the invention is not limited to the embodiment described above, but many variations are possible for those skilled in the art without departing from the scope of the invention. For example, the electrode system present on the surface 2 may have light windows and may comprise electrodes overlapping each other. Furthermore, the electrode system may form instead of the 4-phase clock system shown a 3- or 2-phase clock system. In the latter case and in the case in which the electrode system has light windows, additional semiconductor zones of the second conductivity type may be formed in the channel regions in order to obtain desired potentials in the channel regions. Furthermore the potential beneath the electrode 3 can be adjusted as indicated by curve 28 in Fig. 4, by applying a voltage $V_3$ at the electrode 3 which is between $V_1$ and $V_2$. Thus a potential well 29 is formed as a result of which the sensitivity of the sensor will be improved since charge generated beneath electrode 3 now will flow to the channel region beneath electrodes 4, 5 and 6 instead of to the substrate 1 which is the case when the potential is as indicated by curve 27.

## Claims

1. An image sensor device comprising a semiconductor substrate of the first conductivity type having a number of surface-adjoining channel regions of the first conductivity type which are directed at right angles to a system of electrodes present on and insulated from the surface, in which during operation charge produced by incident radiation is collected and transported and which are mutually separated by surface-adjoining channel separation zones of the second opposite conductivity type and further adjoin a semiconductor zone of the second conductivity type extending substantially parallel to the surface, the channel regions having a doping concentration which exceeds that of the semiconductor zone, which in turn exceeds the doping concentration of the semiconductor substrate, characterized in that the semiconductor zone has a thickness which varies in the direction at right angles to the channel regions, the thickness having minima at the centres of the channel regions.

2. An image sensor device as claimed in Claim 1, characterized in that the semiconductor zone is interrupted at the centres of the channel regions and exhibits slots at this area.

3. An image sensor device as claimed in Claim 2, characterized in that the slots have in the direction at right angles to the channel regions a dimension which exceeds half the thickness of the semiconductor zone, measured just beside the channel separation zones.

4. An image sensor device as claimed in Claim 1, 2 or 3, characterized in that the channel separation zones have in the direction at right angles to the channel separation zones a dimension which is smaller than four times the thickness of the channel regions, measured just beside the channel separation zones.

5. A method of manufacturing an image sensor device as claimed in any one of the preceding Claims, characterized in that zones of the second conductivity type are provided in a semiconductor substrate of the first conductivity type by means of diffusion of impurities *via* a first masking with windows extending at a fixed relative centre distance and then zones of the first conductivity type forming the channel regions are provided *via* a second masking with windows extending at the same relative centre distance, the second masking being arranged so that the channel regions are formed halfway between the zones of the second conductivity type.

6. A method as claimed in Claim 5, characterized in that the two diffusions are effected so that the zones of the second conductivity type do not contact each other, but are separated by regions of the first conductivity type.

**Patentansprüche**

1. Bildsensoranordnung mit einem Halbleitersubstrat eines ersten Leitungstyps mit einer Anzahl an eine Oberfläche desselben grenzender, quer zu einem auf der Oberfläche vorhandenen und gegenüber derselben isolierten Elektrodensystem gerichteter Kanalgebiete vom ersten Leitungstyp, in denen im Betrieb durch eintreffende Strahlung erzeugte Ladung angesammelt und transportiert wird und die durch an die Oberfläche grenzende Kanaltrennzonen vom zweiten Leitungstyp voneinander getrennt sind und weiterhin an eine sich nahezu parallel zu der Oberfläche erstreckende Halbleiterzone von zweiten Leitungstyp grenzen, wobei die Kanalgebiete eine Dotierungskonzentration aufweisen, die höher ist als die der Halbleiterzone, die ihrerseits wieder grösser ist als die Dotierungskonzentration des Halbleitersubstrats, dadurch gekennzeichnet, dass die Halbleiterzone eine Dicke aufweist, die in der Richtung senkrecht zu den Kanalgebieten variiert,

wobei diese Dicke in den Mitten der Kanalgebiete Minima aufweist.

2. Bildsensoranordnung nach Anspruch 1, dadurch gekennzeichnet, dass die Halbleiterzone in den Mitten der Kanalgebiete unterbrochen ist und in diesem Bereich Schlitze aufweist.

3. Bildsensoranordnung nach Anspruch 2, dadurch gekennzeichnet, dass die Schlitze in der Richtung senkrecht zu den Kanalgebieten eine Abmessung haben, die grösser ist als die halbe Dicke der Halbleiterzone, gemessen gerade neben den Kanaltrennzonen.

4. Bildsensoranordnung nach Anspruch 1, 2 oder 3, dadurch gekennzeichnet, dass die Kanaltrennzonen in der Richtung senkrecht zu den Kanaltrennzonen eine Abmessung haben, die kleiner ist als die vierfache Dicke der Kanalgebiete, gemessen gerade neben den Kanaltrennzonen.

5. Verfahren zum Herstellen einer Bildsensoranordnung nach einem der vorstehenden Ansprüche, dadurch gekennzeichnet, dass in einem Halbleitersubstrat vom ersten Leitungstyp durch Diffusion von Verunreinigungen durch eine erste Maskierung mit Fenstern, die einen festen Mittenabstand voneinander aufweisen, Zonen vom zweiten Leitungstyp und danach durch eine zweite Maskierung mit Fenstern, die demselben Mittenabstand aufweisen, die Kanalgebiete bildende Zonen vom ersten Leitungstyp vorgesehen werden, wobei die zweite Maskierung derart angebracht wird, dass die Kanalgebiete mitten zwischen den Zonen vom zweiten Leitungstyp gebildet werden.

6. Verfahren nach Anspruch 5, dadurch gekennzeichnet, dass die zwei Diffusionen derart durchgeführt werden, dass die Zonen vom zweiten Leitungstyp einander nicht berühren sondern durch Gebiete vom ersten Leitungstyp voneinander getrennt werden.

**Revendications**

1. Dispositif capteur d'images comportant un substrat semiconducteur d'un premier type de conductivité muni d'un certain nombre de régions de canal du premier type de conductivité contigués à la surface et perpendiculaires à un système d'électrodes situé sur la surface tout en étant isolé de celle-ci, régions de canal dans lesquelles, en fonctionnement, est accumulée et transportée une charge engendrée par un rayonnement incident et qui, d'une part, sont séparées par des zones de séparation de canal du second type de conductivité contigués à la surface et, d'autre part, sont contigués à une zone semiconductrice du second type de conductivité s'étendant sensiblement parallèlement à la surface, les régions de canal ayant une concentration de dopage supérieure à celle de la zone semiconductrice qui, à sont tour, est supérieure à la concentration de dopage du substrat semiconducteur, caractérisé en ce que la zone semiconductrice a une épaisseur qui varie dans le sens perpendiculaire aux régions de canal, l'épaisseur présentant des minima aux centres des régions de canal.

2. Dispositif capteur d'images selon la revendication 1, caractérisé en ce que la zone semiconductrice est interrompue au centre des régions de canal et présente des fentes à cet endroit.

3. Dispositif capteur d'images selon la revendication 2, caractérisé en ce que, dans le sens perpendiculaire aux régions de canal, les fentes ont une dimension supérieure à la moitié de l'épaisseur de la zone semiconductrice, mesurée juste à côté des zones de séparation de canal.

4. Dispositif capteur d'images selon la revendication 1, 2 ou 3, caractérisé en ce que, dans le sens perpendiculaire aux régions de canal, les zones de séparation de canal ont une dimension inférieure à quatre fois l'épaisseur des régions de canal, mesurée juste à côté des zones de séparation de canal.

5. Procédé de fabrication d'un dispositif capteur d'images selon l'une quelconque des revendications précédentes, caractérisé en ce que, dans un substrat semiconducteur du premier type de conductivité, on forme des zones du second type de conductivité par diffusion d'impuretés à travers un premier masque ayant des fenêtres séparées par une distance de centre en centre fixe et, ensuite, des zones du premier type de conductivité, formant la région de canal, par diffusion d'impuretés à travers un second masque ayant des fenêtres séparées par la même distance de centre en centre, le second masque étant disposé de façon que les régions de canal soient formées au milieu entre les zones du second type de conductivité.

6. Procédé selon la revendication 5, caractérisé en ce que les deux diffusions sont effectuées de façon que les zones du second type de conductivité ne se touchent pas mais qu'elles soient séparées par des régions du premier type de conductivité.

FIG.1

FIG.2

FIG.3

FIG.4

FIG.5

FIG.6

FIG.7